(19) **Europäisches Patentamt**
**European Patent Office**
**Office européen des brevets**

(11) **EP 1 608 073 B1**

(12) **FASCICULE DE BREVET EUROPEEN**

(45) Date de publication et mention
de la délivrance du brevet:
**14.02.2007 Bulletin 2007/07**

(51) Int Cl.:
**H03B 5/12** *(2006.01)*

(21) Numéro de dépôt: **05354021.7**

(22) Date de dépôt: **06.06.2005**

(54) **Oscillateur contrôlé en tension**

**Spannungsgesteuerter Oszillator**

**Voltage controlled oscillator**

(84) Etats contractants désignés:
**AT BE BG CH CY CZ DE DK EE ES FI GB GR HU
IE IS IT LI LT LU MC NL PL PT RO SE SI SK TR**

(30) Priorité: **10.06.2004 FR 0406304**

(43) Date de publication de la demande:
**21.12.2005 Bulletin 2005/51**

(73) Titulaire: **COMMISSARIAT A L'ENERGIE
ATOMIQUE**
**75752 Paris (FR)**

(72) Inventeurs:
• **Geynet, Lionel**
**30250 Fontanes (FR)**
• **De Foucauld, Emeric**
**38170 Seyssinet (FR)**

(74) Mandataire: **Jouvray, Marie-Andrée et al**
**Cabinet Hecké,**
**World Trade Center - Europole,**
**5, place Robert Schuman,**
**B.P. 1537**
**38025 Grenoble Cedex 1 (FR)**

(56) Documents cités:
**US-A1- 2002 167 362     US-A1- 2003 189 466**
**US-B1- 6 292 065       US-B1- 6 574 288**
**US-B1- 6 657 509**

• **PATENT ABSTRACTS OF JAPAN vol. 2003, no.
12, 5 décembre 2003 (2003-12-05) & JP 2004
147310 A (MATSUSHITA ELECTRIC IND CO LTD),
20 mai 2004 (2004-05-20)**

**Description**

**Domaine technique de l'invention**

L'invention concerne un oscillateur contrôlé en tension comportant un réseau oscillant avec un premier condensateur variable, dont la capacité varie en fonction de la tension de contrôle de l'oscillateur.

**État de la technique**

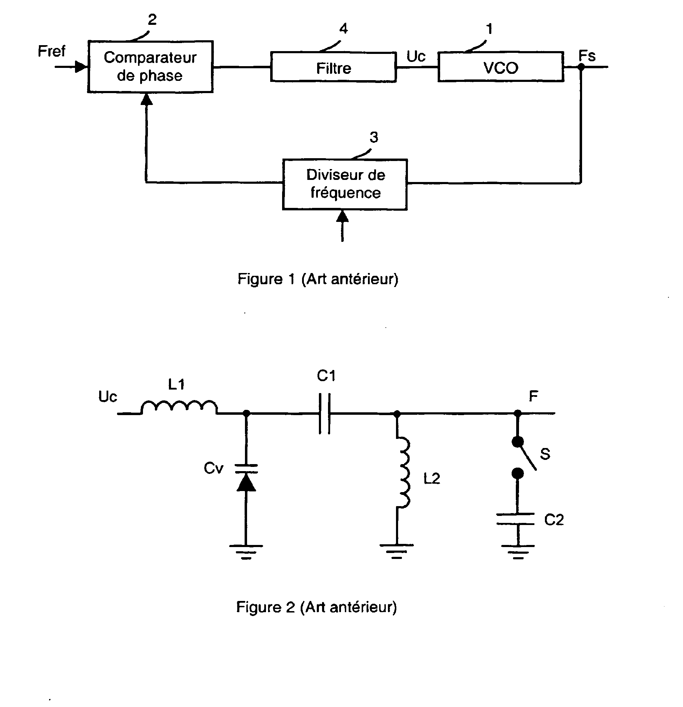

Un oscillateur contrôlé en tension (VCO) fournit des signaux oscillants dont la fréquence varie en fonction d'un signal de tension de contrôle Uc. Les oscillateurs contrôlés en tension sont souvent utilisés dans des boucles à verrouillage de phase, comme représenté à la figure 1. Une telle boucle comporte classiquement un oscillateur 1 contrôlé en tension, dont l'entrée est connectée, par l'intermédiaire d'un filtre 4, à la sortie d'un comparateur de phase 2 et dont la sortie, qui constitue la sortie de la boucle, est connectée à une première entrée du comparateur de phase 2, éventuellement par l'intermédiaire d'un diviseur de fréquence 3. Des signaux d'horloge, ayant une fréquence de référence Fref prédéterminée et par exemple fournis par un oscillateur à quartz, sont appliqués sur une seconde entrée du comparateur de phase 2.

La tension de contrôle Uc de l'oscillateur est ainsi fonction de la différence entre la fréquence Fs des signaux de sortie de l'oscillateur 1, éventuellement affectée d'un coefficient de division, et de la fréquence de référence Fref. Quand la boucle est verrouillée, la fréquence Fs de sortie est ainsi égale à la fréquence de référence Fref ou à un multiple de celle-ci.

Une telle boucle à verrouillage de phase est utilisée dans de nombreux circuits nécessitant une synthèse de fréquence, en particulier dans le domaine des radio-fréquences, pour la réception de signaux modulés. Plusieurs standards de transmission, par exemple des standards de type GSM, GPS ou DCS, des standards utilisant la technologie Bluetooth ou un réseau local sans fil (WLAN), sont souvent utilisés dans un même récepteur, notamment dans les téléphones portables. Il est alors souhaitable de pouvoir passer rapidement d'un standard à une autre, par exemple d'un standard de type GSM à un standard de type Bluetooth.

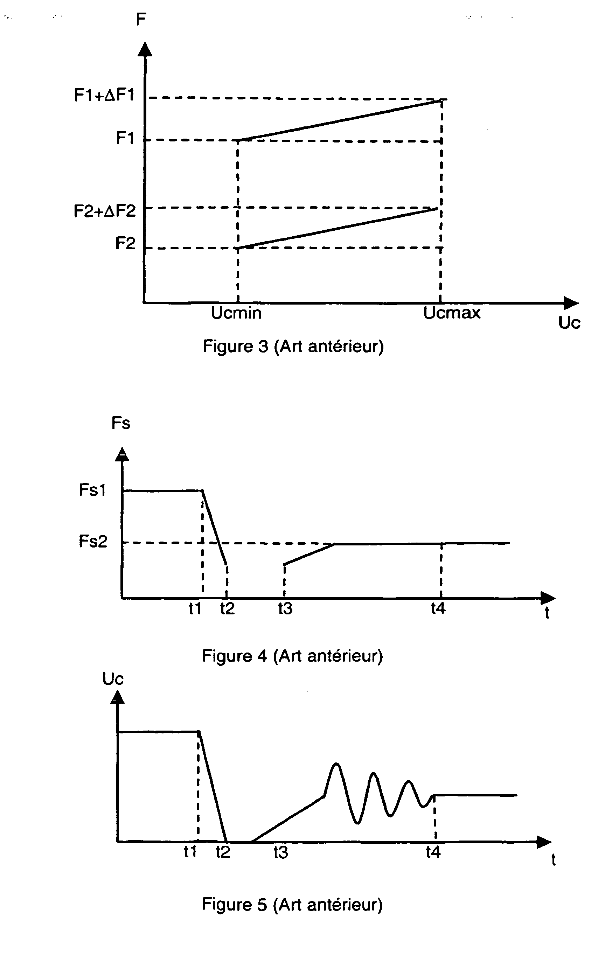

Actuellement, des oscillateurs contrôlés en tension multibande permettent de couvrir plusieurs bandes de fréquences. Un exemple particulier d'oscillateur contrôlé en tension multibande, décrit dans le brevet US 4602222, est illustré à la figure 2. Il comporte un réseau oscillant, de type LC, comportant, en série entre l'entrée et la sortie de l'oscillateur, une première inductance L1 et un condensateur C1. Une seconde inductance L2 est connectée entre la sortie de l'oscillateur et la masse. Un condensateur variable Cv, constitué par une diode à capacité variable, c'est-à-dire par une diode dont la capacité varie en fonction de la tension appliquée à ses bornes, est connecté entre l'entrée de l'oscillateur et la masse. Un condensateur commutable C2 est connecté, en série avec un interrupteur S, entre la sortie de l'oscillateur et la masse. Son insertion dans le réseau oscillant, par fermeture de l'interrupteur S, permet, comme représenté à la figure 3, de passer d'une bande de fréquences (F1 à F1+ΔF1) à une bande de fréquences (F2 à F2+ΔF2) inférieure. À l'intérieur de chaque bande de fréquences, la fréquence F de sortie du réseau oscillant varie linéairement avec la tension de contrôle Uc appliquée à l'entrée de l'oscillateur, qui peut varier entre une tension minimum de contrôle Ucmin et une tension maximum de contrôle Ucmax.

D'autres exemples d'oscillateurs contrôlés en tension multibande sont décrits dans le brevet US 4602222 précité et dans le document US-A-2002/0171499.

Ainsi, l'insertion de condensateurs commutables dans le réseau oscillant d'un oscillateur contrôlé en tension permet de modifier la fréquence d'oscillation et la bande de fréquences couverte. De manière générale, la fréquence F de sortie de l'oscillateur contrôlé en tension est fonction de la valeur de l'inductance L du réseau résonant, de la capacité Cv(Uc) variable du circuit oscillant, fonction de la tension de contrôle Uc, et de la capacité commutée Ccom :

$$F = 1/(2\pi\sqrt{(L(Cv(Uc) + Ccom))})$$

Dans une boucle à verrouillage de phase utilisant un oscillateur contrôlé en tension multibande connu, le passage d'une bande de fréquences à l'autre provoque un décrochage momentané de la boucle à verrouillage de phase. En effet, comme représenté aux figures 4 et 5, l'introduction d'une capacité commutée Ccom à un instant t1 provoque tout d'abord une diminution de la tension de contrôle Uc, à partir d'une première valeur stable, et de la fréquence de sortie Fs, initialement à une valeur stable Fs1. Puis, à un instant t2, la boucle à verrouillage de phase décroche, c'est-à-dire que l'oscillateur contrôlé en tension ne fournit plus aucun signal. Puis, après une durée qui est notamment fonction de la fréquence de coupure du filtre 4, le fonctionnement de la boucle à verrouillage de phase reprend et, à partir d'un instant t3, la fréquence de sortie Fs augmente linéairement jusqu'à une valeur stable Fs2, inférieure à Fs1, tandis que la tension de contrôle Uc oscille avant d'atteindre une seconde valeur stable.

Pour s'affranchir du problème de décrochage d'une boucle à verrouillage de phase utilisant un oscillateur contrôlé en tension multibande permettant de couvrir différents standards, il est possible d'augmenter le gain de l'oscillateur contrôlé en tension, c'est-à-dire le rapport K = F/Uc entre la fréquence F de ses signaux de sortie et la tension de contrôle Uc appliquée sur son entrée, de manière à couvrir toute la gamme de fréquences désirée sans commuter brutalement de nouveaux condensateurs. Or, plus le gain est élevé, plus le bruit de phase généré est important, ce qui présente un nouvel inconvénient.

**Objet de l'invention**

L'invention a pour but de surmonter ces inconvénients et, plus particulièrement, de réaliser un oscillateur contrôlé en tension dont le bruit de phase est réduit. Dans le cas d'un oscillateur multibande, celui-ci ne doit pas provoquer de décrochage lors de la commutation d'une bande à une autre lorsqu'il est disposé dans une boucle à verrouillage de phase.

Selon l'invention, ce but est atteint par les revendications annexées et plus particulièrement par le fait que l'oscillateur comporte un second condensateur variable, dont la capacité est variable en fonction de la tension qui lui est appliquée, des moyens de commutation connectés aux premier et second condensateurs variables et des moyens de contrôle des moyens de commutation provoquant, en fonction de la fréquence de sortie de l'oscillateur, le remplacement dans le réseau oscillant de l'un des condensateurs variables par l'autre, la capacité de l'un des condensateurs variable variant dans le même sens que la tension qui lui est appliquée et la capacité de l'autre condensateur variable variant en sens inverse par rapport à la tension qui lui est appliquée.

**Description sommaire des dessins**

D'autres avantages et caractéristiques ressortiront plus clairement de la description qui va suivre de modes particuliers de réalisation de l'invention donnés à titre d'exemples non limitatifs et représentés aux dessins annexés, dans lesquels :

La figure 1 illustre schématiquement une boucle à verrouillage de phase de type classique.
La figure 2 illustre un oscillateur contrôlé en tension multibande selon l'art antérieur.
La figure 3 illustre les variations de la fréquence de sortie F d'un oscillateur selon la figure 2 en fonction de sa tension de contrôle Uc.
Les figures 4 et 5 illustrent les variations, en fonction du temps, respectivement de la fréquence de sortie Fs d'une boucle à verrouillage de phase utilisant un oscillateur contrôlé en tension selon l'art antérieur et de la tension de contrôle Uc de l'oscillateur lors d'un changement de bande de fréquences.
La figure 6 représente un mode particulier de réalisation d'un oscillateur selon l'invention.
La figure 7 illustre les variations de la fréquence de sortie F d'un oscillateur selon l'invention en fonction de sa tension de contrôle Uc.
La figure 8 illustre les variations de la capacité de condensateurs variables Cv+ et Cv- pouvant être utilisés dans un oscillateur selon l'invention, en fonction de la tension de commande U qui est appliquée à leurs bornes.
Les figures 9 et 10 illustrent les variations de la fréquence de sortie F d'un oscillateur en fonction de sa tension de contrôle Uc, respectivement pour deux modes particuliers de réalisation d'un oscillateur selon l'invention comportant des condensateurs commutables.
Les figures 11 et 12 illustrent les variations, en fonction du temps, respectivement de la fréquence de sortie Fs d'une boucle à verrouillage de phase utilisant un oscillateur contrôlé en tension multibande selon l'invention et de la tension de contrôle Uc de l'oscillateur lors d'un changement de bande de fréquences.

**Description de modes particuliers de réalisation**

Un oscillateur contrôlé en tension selon l'invention comporte un réseau oscillant dans lequel sont alternativement introduits deux condensateurs variables Cv+ et Cv-, les capacités des deux condensateurs variables Cv+ et Cv- variant en sens opposés par rapport à la tension qui leur est appliquée.

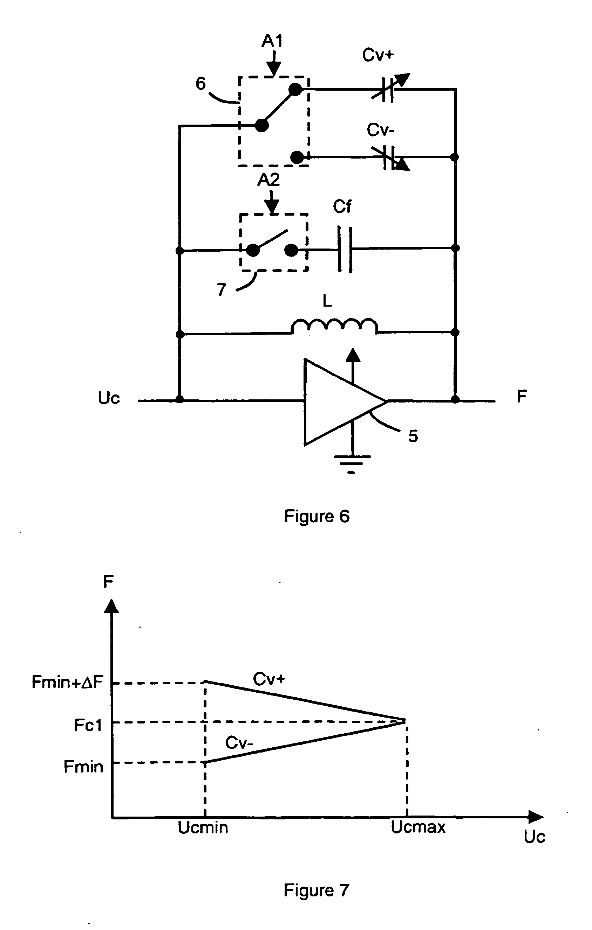

Dans le mode particulier de réalisation représenté à la figure 6, le réseau oscillant comporte un amplificateur 5 connecté, en parallèle avec une inductance L, entre l'entrée de contrôle et la sortie de l'oscillateur. Les deux condensateurs variables Cv+ et Cv- sont connectés, en série avec un commutateur 6, entre l'entrée et la sortie de l'oscillateur. Le commutateur 6 est contrôlé par des signaux A1 de contrôle fournis par un circuit de contrôle (non représenté), de manière à connecter alternativement les condensateurs variables Cv+ et Cv- en parallèle avec l'inductance L, en fonction de la fréquence de sortie de l'oscillateur.

Dans un mode de réalisation particulier, le commutateur 6 comporte une borne commune connectée à une extrémité de l'inductance L, par exemple à l'entrée de l'oscillateur sur la figure 6, et deux bornes connectées respectivement à des premières extrémités des condensateurs variables Cv+ et Cv-. Dans une variante, non représentée, deux interrupteurs connectés en série respectivement avec les condensateurs Cv+ et Cv-, sont contrôlés par des signaux complémentaires, de manière à ce que l'un des interrupteurs soit ouvert quand l'autre est fermé.

La fréquence minimale d'oscillation Fmin de l'oscillateur correspond à la fréquence d'oscillation, à la tension de contrôle minimum Ucmin, du réseau résonant LC. La capacité du réseau résonant correspond alors à la valeur maximale intrinsèque du condensateur variable initialement inséré dans le réseau oscillant, éventuellement associée à la capacité d'un condensateur fixe non commutable du réseau oscillant : Fmin = F(Cv, Ucmin)

Ainsi, comme représenté à la figure 7, lorsque seul le condensateur Cv-, dont la capacité varie dans le sens contraire de la tension, est initialement connecté en parallèle avec l'inductance L, la fréquence F de sortie de l'oscillateur 6 augmente linéairement avec la tension de contrôle Uc entre la fréquence minimale d'oscillation Fmin et une valeur de commutation Fc1 prédéterminée. La valeur de commutation Fc1 correspond à la fréquence de sortie maximale obtenue, dans cette configuration, avec la tension maximale Ucmax de la tension de contrôle Uc : Fc1 = F(Cv-, Ucmax)

Lorsque la fréquence F de sortie de l'oscillateur atteint la valeur de commutation Fc1, le circuit de contrôle fournit un signal de commutation A1 au commutateur 6, provoquant automatiquement le remplacement du condensateur Cv- par le condensateur Cv+ dans le réseau oscillant. Les caractéristiques respectives des condensateurs Cv- et Cv+ sont telles que F(Cv-, Ucmax) = F(Cv+, Ucmax). Il n'y a donc ni modification de la fréquence d'oscillation de l'oscillateur ni modification brusque de la tension de contrôle Uc à l'instant où le condensateur Cv- est remplacé par le condensateur Cv+ et inversement. La fréquence F de sortie de l'oscillateur 6 continue ensuite, lorsque la tension de contrôle Uc diminue, à augmenter linéairement entre la valeur de commutation Fc1 et une fréquence d'oscillation Fmin+ΔF = F(Cv+, Ucmin).

L'oscillateur contrôlé en tension couvre ainsi une bande de fréquences de fonctionnement ΔF, comprise entre Fmin = F(Cv-, Ucmin) et Fmin+ΔF = F(Cv+, Ucmin) et divisée en deux parties, dans lesquelles la fréquence varie alternativement dans le même sens que la tension de contrôle et en sens inverse, de part et d'autre de la fréquence de commutation Fc1. Ceci permet de diminuer le gain K de l'oscillateur et, en conséquence, de diminuer le bruit de phase dans l'oscillateur.

Le condensateur Cv+ peut être initialement inséré dans le réseau oscillant à la place du condensateur Cv-. Dans ce cas, le cheminement est inversé. La fréquence minimale de l'oscillateur est alors donnée par F(Cv+, Ucmax) et, tandis que la tension de contrôle Uc diminue, la fréquence d'oscillation augmente jusqu'à la fréquence de commutation F(Cv+, Ucmin), correspondant à la fréquence d'oscillation maximale du réseau avec le condensateur variable Cv+. Celui-ci est alors remplacé par le condensateur Cv-, avec F(Cv+, Ucmin) = F(Cv-, Ucmin). La fréquence continue alors d'augmenter, avec la tension de contrôle, jusqu'à ce que la fréquence de sortie de l'oscillateur atteigne la valeur F(Cv-, Ucmax).

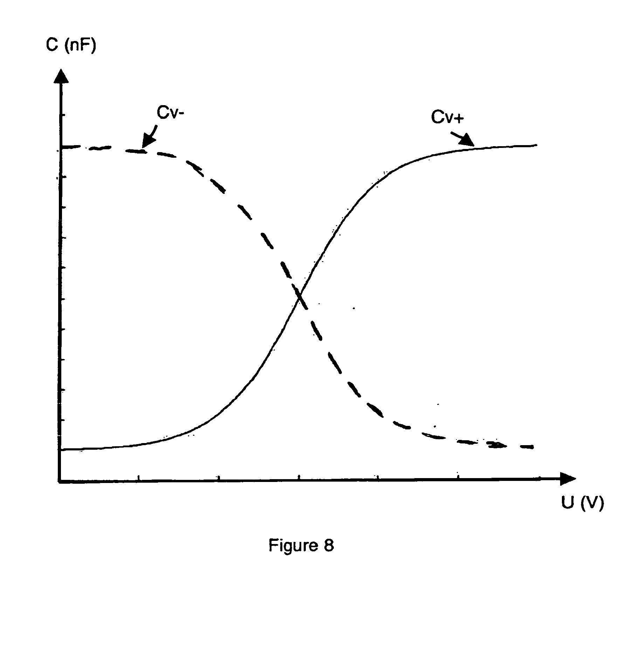

Les condensateurs variables Cv+ et Cv-peuvent être constituées par tout moyen approprié et, plus particulièrement, par des varactors, de type diode ou de type transistor (PMOS et NMOS), ou par des capacités à base de MEMs. La figure 8 illustre un exemple des variations de la capacité de condensateurs variables Cv- et Cv+, constitués respectivement par des transistors NMOS et PMOS, en fonction de la tension U qui est appliquée à leurs bornes.

Comme représenté à la figure 6, l'oscillateur peut également comporter au moins un condensateur additionnel Cf, de capacité fixe, connecté en série avec un commutateur additionnel 7, aux bornes de l'inductance L.

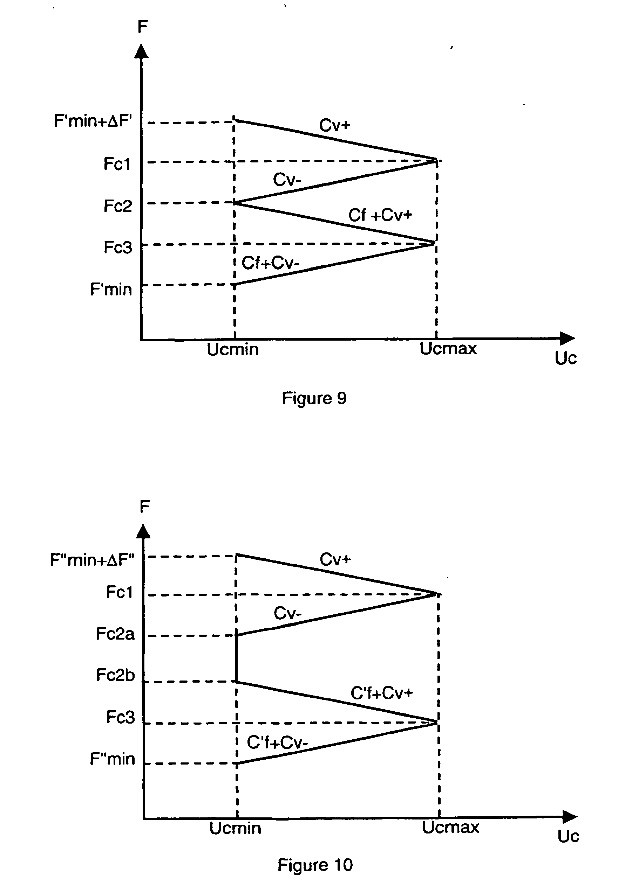

Dans une première variante, illustrée à la figure 9, le réseau oscillant comporte initialement uniquement le condensateur Cv+. La fréquence initiale, à la tension de contrôle Ucmin, correspond alors à la fréquence maximum F'min+ΔF' = F(Cv+, Ucmin). Comme précédemment, la fréquence diminue linéairement lorsque la tension de contrôle Uc augmente, jusqu'à la fréquence de commutation Fc1 = F(Cv+, Ucmax) = F(Cv-, Ucmax). Lorsque la fréquence atteint la valeur de commutation Fc1, le condensateur Cv+ est remplacé par le condensateur Cv-. La fréquence F de sortie de l'oscillateur continue ensuite, lorsque la tension de contrôle Uc diminue, à diminuer linéairement entre la valeur de commutation Fc1 et une valeur de commutation Fc2 = F(Cv-, Ucmin). Le condensateur additionnel Cf est inséré dans le réseau oscillant lorsque la fréquence de sortie F de l'oscillateur atteint la valeur de commutation Fc2. Le circuit de contrôle fournit alors simultanément un signal A1 de commutation au commutateur 6 et un signal A2 de commutation au commutateur additionnel 7. Dans le mode de réalisation particulier illustré aux figures 6 et 9, le condensateur additionnel Cf est donc inséré dans le réseau oscillant, par fermeture du commutateur 7, lorsque la fréquence de sortie de l'oscillateur atteint la fréquence de commutation Fc2, qui provoque simultanément le remplacement du condensateur Cv- par le condensateur Cv+. La valeur de la capacité du condensateur fixe Cf est choisie de telle sorte que l'insertion du condensateur Cf et le remplacement simultané de Cv- par Cv+ ne modifie ni la fréquence de sortie de l'oscillateur, ni la tension de contrôle. Pour cela, la fréquence d'oscillation maximale du réseau oscillant avec le condensateur fixe Cf est égale à la fréquence d'oscillation minimale du réseau oscillant sans ce condensateur :

$$Fc2 = F(Cv-, Ucmin) = F(Cf \text{ et } Cv+, Ucmin).$$

La combinaison de l'insertion du condensateur Cf et de la nouvelle inversion du sens de variation de la capacité variable en fonction de la tension de contrôle, permet ainsi à la fréquence de sortie de l'oscillateur de continuer à diminuer, tandis que la tension de contrôle augmente, jusqu'à une valeur de commutation Fc3, qui provoque alors le remplacement du condensateur Cv+ par le condensateur Cv-, avec : Fc3 = F(Cf et Cv+, Ucmax) = F(Cf et Cv-, Ucmax).

La fréquence continue ensuite à diminuer avec la tension de contrôle, jusqu'à une fréquence F'min = F(Cf et Cv-, Ucmin). La bande de fréquences ΔF' est ainsi divisée en quatre parties, dans lesquelles la fréquence varie alternativement dans le sens contraire de la tension de contrôle et dans le même sens, l'alternance étant provoquée à chaque fois que la fréquence de sortie atteint une valeur de commutation Fc1, Fc2 ou Fc3.

L'oscillateur peut comporter plusieurs condensateurs fixes commutables. Un premier condensateur fixe Cf1 étant, comme ci-dessus, inséré dans le réseau oscillant lorsque la fréquence de sortie de l'oscillateur atteint la valeur de commutation Fc2 = F(Cv-, Ucmin) = F(Cf1 et Cv+, Ucmin), un second condensateur fixe Cf2 peut être inséré dans le réseau oscillant lorsque la fréquence atteint une valeur de commutation F(Cf1 et Cv-, Ucmin) = F(Cf1, Cf2 et Cv+, Ucmin).

D'autres condensateurs fixes Cfi, avec i=1 à n, peuvent ainsi être sélectivement insérés dans le réseau oscillant lorsque la fréquence F atteint des valeurs de commutation correspondantes F(Cf1, Cf2...Cfi-1 et Cv-, Ucmin) = F(Cf1, Cf2...Cfi et Cv+, Ucmin). La bande de fréquences peut ainsi être divisée en 2n+2 parties.

Si le condensateur variable initialement inséré dans le réseau oscillant, lorsque la fréquence est maximale (F'min+ΔF'), est le condensateur Cv- à la place du condensateur Cv+, l'insertion d'un condensateur fixe Cfi est réalisée lorsque la fréquence atteint une fréquence de commutation F(Cf1, Cf2...Cfi-1 et Cv+, Ucmax) = F (Cf1, Cf2...Cfi et Cv-, Ucmax).

Dans la variante illustrée aux figures 6 et 10, la valeur de la capacité du condensateur fixe C'f est choisie de telle sorte que l'insertion du condensateur C'f et le remplacement simultané de Cv+ par Cv-, lorsque la fréquence atteint une valeur de commutation Fc2a = F(Cv-, Ucmin), provoque un saut de fréquence. La fréquence de sortie de l'oscillateur passe alors de la fréquence Fc2a, correspondant à la fréquence d'oscillation minimale du réseau oscillant sans le condensateur fixe C'f, à une valeur Fc2b = F(C'f et Cv+, Ucmin), inférieure à Fc2a et correspondant à la fréquence d'oscillation maximale du réseau oscillant avec le condensateur fixe C'f. Inversement, le retrait du condensateur fixe C'f lorsque la fréquence de sortie de l'oscillateur remonte à la valeur F2b et le remplacement simultané de Cv+ par Cv- fait passer la fréquence de sortie de l'oscillateur à la valeur Fc2a. Dans les deux cas, la tension de contrôle reste à sa valeur Ucmin pendant la commutation.

Comme précédemment, l'oscillateur peut comporter plusieurs condensateurs fixes commutables C'fi, avec i=1 à n, insérés sélectivement dans le réseau oscillant ou écartés sélectivement de celui-ci. Un condensateur C'fi est ainsi inséré dans le réseau oscillant lorsque la fréquence F atteint la valeur de commutation F(C'f1, C'f2....C'fi-1 et Cv-, Ucmin), faisant alors passer la fréquence F à une valeur inférieure F(C'f1, C'f2...C'fi et Cv+, Ucmin).

La variante illustrée à la figure 10 peut être utilisée aussi bien à l'intérieur d'une bande de fréquences, entre F"min et F"min+ΔF", comme décrit ci-dessus, que pour réaliser un oscillateur contrôlé en tension multibande. Celui-ci permet alors de passer d'une première bande de fréquences, comprise entre F1 = Fc2a et F1+ΔF1 = F"min+ΔF", à une seconde bande de fréquences, inférieure à la première, comprise entre F2 = F"min et F2+ΔF2 = Fc2b, et inversement. Dans ce cas, les signaux de commutation A2 contrôlant l'insertion des condensateurs fixes commutables ne sont pas fournis par le circuit de contrôle en même temps que les signaux A1 de contrôle du commutateur A1, mais peuvent être appliqués à tout instant, soit par une commande manuelle de l'utilisateur, soit par un contrôle à distance.

Plus généralement, l'oscillateur peut permettre le passage d'une bande de fréquences, comprise entre Fi et Fi+ΔFi, à une bande de fréquences inférieure, comprise entre F(i+1) et F(i+1)+ΔF(i+1), par remplacement d'un condensateur variable par l'autre et insertion simultanée d'un condensateur fixe C'fi, avec i = 1 à n, dont la capacité est telle que l'écart entre la fréquence inférieure F(i-1) d'une bande de fréquences et la fréquence supérieure Fi+ΔFi de la bande immédiatement inférieure soit donnée par :

$$F(i-1) - (Fi+\Delta Fi) = F(C'f1, C'f2...C'fi-1 \text{ et } Cv-, Ucmin) - F(C'f1, C'f2...C'fi \text{ et } Cv+, Ucmin)$$

avec

$$\Delta Fi = F(C'f1, C'f2\ldots C'fi\ et\ Cv+,\ Ucmin) - F(C'f1, C'f2\ldots C'fi\ et\ Cv-,\ Ucmin)$$

Comme précédemment, l'insertion des condensateurs fixes peut se faire soit lors du remplacement de Cv- par Cv+, à Ucmin, soit lors du remplacement de Cv+ par Cv-, à Ucmax.

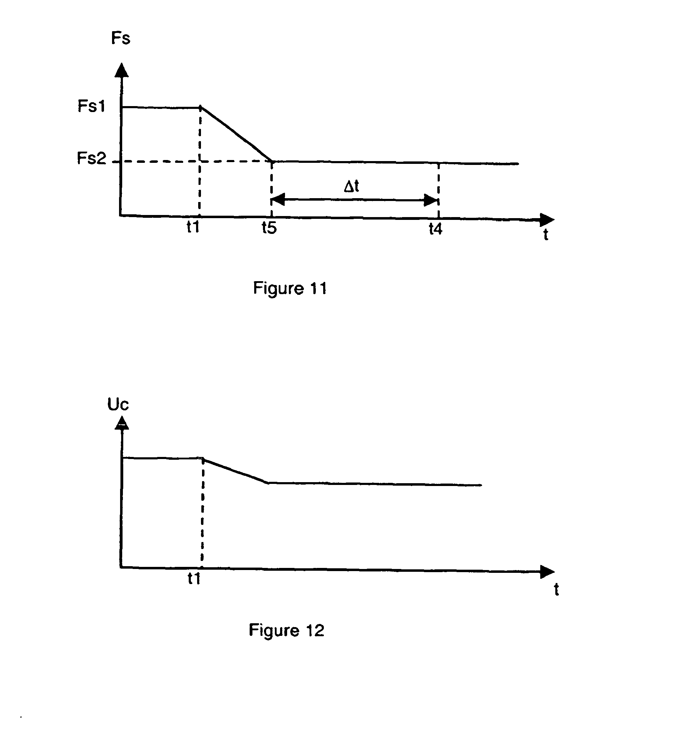

Lorsqu'un tel oscillateur contrôlé en tension multibande est utilisé dans une boucle à verrouillage de phase, il n'y a pas de décrochage de celle-ci lors du passage d'une bande de fréquences à une autre, grâce à l'alternance des condensateurs variables. Les figures 11 et 12 illustrent les variations en fonction du temps, respectivement de la fréquence Fs de sortie de la boucle de verrouillage de phase et de la tension de contrôle Uc de l'oscillateur contrôlé en tension selon l'invention inclus dans la boucle à verrouillage de phase, lors du passage d'une fréquence Fs1 d'une première bande de fréquences à une fréquence Fs2, inférieure, d'une seconde bande de fréquences. Comme sur les figures 4 et 5, le condensateur fixe est inséré à l'instant t1. La tension de contrôle Uc diminue linéairement jusqu'à un instant t5, où la fréquence de sortie atteint la nouvelle valeur stable désirée Fs2. Pendant cet intervalle de temps, les condensateurs variables Cv+ et Cv- ont alternativement été insérés dans le réseau oscillant en fonction de la valeur de la fréquence de sortie Fs. L'instant t5 d'obtention de la fréquence de sortie est nettement antérieur à l'instant t4 correspondant dans les boucles de phase utilisant un oscillateur contrôlé en tension multibande connu (figures 4 et 5). L'utilisation d'un oscillateur multibande selon l'invention permet ainsi un gain de temps Δt = t4 - t5 à la commutation. Il n'y a ni saut de tension, ni décrochage de la boucle à verrouillage de phase. De plus, l'absence de variation brusque de la tension de contrôle lors de la commutation permet de réduire le bruit généré lors de la commutation.

## Revendications

**1.** Oscillateur contrôlé en tension comportant un réseau oscillant avec un premier condensateur variable (Cv), dont la capacité varie en fonction de la tension de contrôle (Uc) de l'oscillateur, oscillateur **caractérisé en ce qu'**il comporte un second condensateur variable, dont la capacité est variable en fonction de la tension qui lui est appliquée, des moyens de commutation (6) connectés aux premier et second condensateurs variables et des moyens de contrôle des moyens de commutation provoquant, en fonction de la fréquence (F) de sortie de l'oscillateur, le remplacement dans le réseau oscillant de l'un des condensateurs variables par l'autre, la capacité de l'un des condensateurs variable (Cv+) variant dans le même sens que la tension qui lui est appliquée et la capacité de l'autre condensateur variable (Cv-) variant en sens inverse par rapport à la tension qui lui est appliquée.

**2.** Oscillateur selon la revendication 1, **caractérisé en ce qu'**une bande (Fmin à Fmin+ΔF) de fréquences de fonctionnement de l'oscillateur est divisée en au moins deux parties, dans lesquelles la fréquence varie alternativement dans le même sens que la tension de contrôle et en sens inverse.

**3.** Oscillateur selon l'une des revendications 1 et 2, **caractérisé en ce que** les moyens de contrôle comportent des moyens pour fournir un signal de commutation (A1) aux moyens de commutation (6) provoquant le changement de condensateur variable (Cv+, Cv-) dans le réseau oscillant lorsque la fréquence (F) de sortie de l'oscillateur atteint une valeur de commutation prédéterminée (Fc1, Fc2, Fc3), correspondant à la fréquence d'oscillation maximale du réseau oscillant avec l'un des condensateurs variables (Cv+, Cv-).

**4.** Oscillateur selon la revendication 3, **caractérisé en ce qu'**il comporte au moins un condensateur additionnel (Cf), de capacité prédéterminée fixe, et des moyens de commutation additionnels (7), connectés en série avec le condensateur additionnel (Cf), pour insérer sélectivement le condensateur additionnel (Cf) dans le réseau oscillant ou l'en écarter.

**5.** Oscillateur selon la revendication 3, **caractérisé en ce que** la capacité du condensateur additionnel (Cf) est telle que son insertion dans le réseau oscillant provoque le passage de l'oscillateur d'une bande (F1 à F1+ΔF1) de fréquences de fonctionnement à une bande inférieure (F2 à F2+ΔF2).

**6.** Oscillateur selon l'une des revendications 4 et 5, **caractérisé en ce que** les moyens de contrôle comportent des moyens pour fournir un signal de commutation (A2) aux moyens de commutation additionnels (7) pour provoquer l'insertion dans le réseau oscillant d'un condensateur additionnel (Cf) lorsque la fréquence (F) de sortie de l'oscillateur atteint l'une (Fc2) desdites valeurs de commutation, la capacité dudit condensateur additionnel (Cf) étant telle que la fréquence (Fc2, Fc2b) d'oscillation maximale du réseau oscillant avec ledit condensateur additionnel (Cf) soit égale ou inférieure à la fréquence (Fc2, Fc2a) d'oscillation minimale du réseau oscillant sans ledit condensateur additionnel.

7. Oscillateur selon l'une quelconque des revendications 1 à 6, **caractérisé en ce que** le réseau oscillant comporte un amplificateur (5) connecté, en parallèle avec une inductance (L), entre une entrée de contrôle de l'oscillateur et une sortie de l'oscillateur, les condensateurs (Cv+, Cv-, Cf) étant respectivement connectés, en série avec les moyens de commutation correspondants (6, 7), entre l'entrée de contrôle et la sortie de l'oscillateur.

8. Oscillateur selon la revendication 7, **caractérisé en ce que** les moyens de commutation comportent un commutateur (6) comportant une borne commune connectée à une extrémité de l'inductance (L) et deux bornes connectées respectivement à des premières extrémités des premier et second condensateurs variables (Cv+, Cv-).

9. Oscillateur selon l'une quelconque des revendications 1 à 8, **caractérisé en ce que** les premier et second condensateurs variables (Cv+, Cv-) sont constitués par des transistors, respectivement de type PMOS et NMOS.

**Claims**

1. Voltage controlled oscillator comprising an oscillating system with a first variable capacitor (Cv) having a capacitance varying according to the control voltage (Uc) of the oscillator, oscillator **characterized in that** it comprises a second variable capacitor having a capacitance varying according to the voltage applied thereto, switching means (6) connected to the first and second variable capacitors, and control means for controlling the switching means causing, according to the output frequency (F) of the oscillator, one of the variable capacitors to be replaced by the other in the oscillating system, the capacitance of one of the variable capacitors (Cv+) varying in the same direction as the voltage that is applied thereto and the capacitance of the other variable capacitor (Cv-) varying in the opposite direction to the voltage that is applied thereto.

2. Oscillator according to claim 1, **characterized in that** an operating frequency band (Fmin to Fmin+$\Delta$F) of the oscillator is divided into at least two parts in which the frequency varies alternately in the same direction as the control voltage and in the opposite direction.

3. Oscillator according to one of claims 1 and 2, **characterized in that** the control means comprise means for supplying to the switching means (6) a switching signal (A1) causing changing of the variable capacitor (Cv+, Cv-) in the oscillating system when the output frequency (F) of the oscillator reaches a predetermined switching value (Fc1, Fc2, Fc3) corresponding to the maximum oscillation frequency of the oscillating system with one of the variable capacitors (Cv+, Cv-).

4. Oscillator according to claim 3, **characterized in that** it comprises at least one additional capacitor (Cf), of fixed predetermined capacitance, and additional switching means (7) connected in series with the additional capacitor (Cf) to selectively connect the additional capacitor (Cf) in the oscillating system or remove it therefrom.

5. Oscillator according to claim 3, **characterized in that** the capacitance of the additional capacitor (Cf) is such that connection thereof in the oscillating system causes switching of the oscillator from one operating frequency band (F1 to F1+$\Delta$F1) to a lower band (F2 to F2+$\Delta$F2).

6. Oscillator according to one of claims 4 and 5, **characterized in that** the control means comprise means for supplying a switching signal (A2) to the additional switching means (7) to cause an additional capacitor (Cf) to be connected in the oscillating system when the output frequency (F) of the oscillator reaches one (Fc2) of said switching values, the capacitance of said additional capacitor (Cf) being such that the maximum oscillation frequency (Fc2, Fc2b) of the system with said additional capacitor (Cf) is equal to or lower than the minimum oscillation frequency (Fc2, Fc2a) of the oscillating system without said additional capacitor.

7. Oscillator according to any one of claims 1 to 6, **characterized in that** the oscillating system comprises an amplifier (5) connected in parallel with an inductor (L) between a control input of the oscillator and an output of the oscillator, the capacitors (Cv+, Cv-, Cf) being respectively connected, in series with the corresponding switching means (6, 7), between the control input and the output of the oscillator.

8. Oscillator according to claim 7, **characterized in that** the switching means comprise a changeover switch (6) comprising a common terminal connected to one end of the inductor (L) and two terminals respectively connected to first ends of the first and second variable capacitors (Cv+, Cv-).

9.  Oscillator according to any one of claims 1 to 8, **characterized in that** the first and second variable capacitors (Cv+, Cv-) are formed by transistors respectively of PMOS and NMOS type.


**Patentansprüche**

1.  Spannungsgesteuerter Oszillator, der einen Schwingkreis mit einem ersten variablen Kondensator (Cv) umfasst, dessen Kapazität abhängig von der Steuerspannung (Uc) des Oszillators schwankt, Oszillator, der **dadurch gekennzeichnet ist, dass** er einen zweiten variablen Kondensator umfasst, dessen Kapazität abhängig von der an ihn angelegten Spannung variabel ist, Schaltvorrichtungen (6), die an den ersten und zweiten variablen Kondensator geschaltet sind, und Mittel zum Steuern der Schaltvorrichtungen, die je nach Ausgangsfrequenz (F) des Oszillators im Schwingkreis das Ersetzen eines der variablen Kondensatoren durch den anderen bewirken, wobei die Kapazität eines der variablen Kondensatoren (Cv+) in gleicher Richtung schwankt wie die an ihn angelegte Spannung und die Kapazität des anderen variablen Kondensators (Cv-) in entgegengesetzter Richtung bezüglich der an ihn angelegten Spannung schwankt.

2.  Oszillator nach Anspruch 1, **dadurch gekennzeichnet, dass** ein Betriebs-Frequenzbereich (Fmin bis Fmin+ΔF) des Oszillators in mindestens zwei Bereiche geteilt ist, in denen die Frequenz abwechseln in gleicher Richtung wie die Steuerspannung und in entgegengesetzter Richtung schwankt.

3.  Oszillator nach einem der Ansprüche 1 und 2, **dadurch gekennzeichnet, dass** die Steuermittel Vorrichtungen zum Abgeben eines Schaltsignals (A1) an die Schaltvorrichtungen (6) umfassen, das den Wechsel des variablen Kondensators (Cv+, Cv-) im Schwingkreis auslöst, wenn die Ausgangsfrequenz (F) des Oszillators einen vorbestimmten Schaltwert (Fc1, Fc2, Fc3) erreicht, der der maximalen Schwingfrequenz des Schwingkreises mit einem der variablen Kondensatoren (Cv+, Cv-) entspricht.

4.  Oszillator nach Anspruch 3, **dadurch gekennzeichnet, dass** er mindestens einen zusätzlichen Kondensator (Cf) mit vorbestimmter fester Kapazität umfasst, sowie zusätzliche Schaltvorrichtungen (7), die in Serie mit dem zusätzlichen Kondensator (Cf) geschaltet sind, um den zusätzlichen Kondensator (Cf) in den Schwingkreis zu schalten oder ihn herauszunehmen.

5.  Oszillator nach Anspruch 3, **dadurch gekennzeichnet, dass** die Kapazität des zusätzlichen Kondensators (Cf) dergestalt ist, dass sein Schalten in den Schwingkreis den Übergang des Oszillators von einem Betriebs-Frequenzbereich (F1 bis F1 + ΔF1) zu einem niedrigeren Frequenzbereich (F2 bis F2+ΔF2) bewirkt.

6.  Oszillator nach einem der Ansprüche 4 und 5, **dadurch gekennzeichnet, dass** die Steuermittel Vorrichtungen zum Abgeben eines Schaltsignals (A2) an die zusätzlichen Schaltvorrichtungen (7) umfassen, das das Schalten eines zusätzlichen Kondensators (Cf) in den Schwingkreis bewirkt, wenn die Ausgangsfrequenz (F) des Oszillators einen (Fc2) der Schaltwerte erreicht, wobei die Kapazität des zusätzlichen Kondensators (Cf) dergestalt ist, dass die maximale Schwingfrequenz (Fc2, Fc2b) des Schwingkreises mit dem zusätzlichen Kondensator (Cf) gleich der minimalen Schwingfrequenz (Fc2, Fc2a) des Schwingkreises oder kleiner als diese ohne den zusätzlichen Kondensator ist.

7.  Oszillator nach einem der Ansprüche **1** bis 6, **dadurch gekennzeichnet, dass** der Schwingkreis einen Verstärker (5) umfasst, der mit einer Induktivität (L) zwischen einem Steuereingang des Oszillators und einem Ausgang des Oszillators parallelgeschaltet ist, wobei die Kondensatoren (Cv+, Cv-, Cf) jeweils in Serie mit den entsprechenden Schaltvorrichtungen (6, 7) zwischen dem Steuereingang und dem Ausgang des Oszillators geschaltet sind.

8.  Oszillator nach Anspruch 7, **dadurch gekennzeichnet, dass** die Schaltvorrichtungen einen Schalter (6) mit einer gemeinsamen Klemme umfassen, die an ein Ende der Induktivität (L) gelegt ist, sowie zwei Klemmen, die jeweils an erste Enden des ersten und zweiten variablen Kondensators (Cv+, Cv-) gelegt sind.

9.  Oszillator nach einem der Ansprüche 1 bis 8, **dadurch gekennzeichnet, dass** der erste und zweite variable Kondensator (Cv+, Cv-) aus Transistoren bestehen, und zwar einem PMOS- bzw. NMOS-Transistor.

Figure 1 (Art antérieur)

Figure 2 (Art antérieur)

Figure 3 (Art antérieur)

Figure 4 (Art antérieur)

Figure 5 (Art antérieur)

Figure 6

Figure 7

Figure 8

Figure 9

Figure 10

Figure 11

Figure 12